# FASCICULE DE BREVET EUROPEEN

(11) **EP 0 786 840 B1**
(45) Date de publication et mention de la délivrance du brevet: **20.06.2001**
(21) Numéro de dépôt: 97400154.7
(22) Date de dépôt: 23.01.1997
(51) Int. Cl.: H01S 5/10, H01L 21/306

(54) **Procédé pour la réalisation d'un plan incliné à 45 degrés sur un substrat d'InP et composant optique**
Herstellungsverfahren für eine um 45 Grad geneigte Kristallfläche auf einem InP Substrat und optische Vorrichtung
Method of making a 45 degree inclined plane on an InP substrate and optical device

(30) Priorité: 25.01.1996 FR 9600847
(43) Date de publication de la demande: 30.07.1997
(73) Titulaire: FRANCE TELECOM, 75015 Paris (FR)
(72) Inventeur: Menigaux, Louis, 91440 Bures sur Yvette (FR)
(74) Mandataire: Martin, Jean-Jacques

(56) Documents cités:
- US-A- 4 595 454
- IBM TECHNICAL DISCLOSURE BULLETIN, vol. 32, no. 12, 1 Mai 1990, pages 19-21, XP000105055 "IMPROVED NORMAL-EMISSION REFLECTOR FOR STRIPE LASERS USING SUBLIME TECHNOLOGY"
- PROCEEDINGS OF THE INDIUM PHOSPHIDE AND RELATED MATERIALS CONFERENC, DENVER, APR. 23 - 25, 1990, vol. VOL. 1, no. CONF. 2, 23 Avril 1990, INSTITUTE OF ELECTRICAL AND ELECTRONICS ENGINEERS, pages 73-79, XP000170194 BAILEY S ET AL: "APPLICATION OF V-GROOVE TECHNOLOGY TO INP SOLAR CELLS"
- PATENT ABSTRACTS OF JAPAN vol. 013, no. 503 (E-844), 13 Novembre 1989 & JP 01 201981 A (MATSUSHITA ELECTRIC IND CO LTD), 14 Août 1989,
- GALLIUM ARSENIDE AND RELATED COMPOUNDS, KARUIZAWA, SEPT. 28 - OCT. 2, 1992, no. SYMP. 19, 28 Septembre 1992, IKEGAMI T;HASEGAWA F; TAKEDA Y, pages 797-802, XP000366297 TOYOHARU OHATA ET AL: "SURFACE-EMITTING LASER DIODES EMPLOYING GROWN-IN 45 MIRRORS"
- IEEE JOURNAL OF QUANTUM ELECTRONICS, vol. 31, no. 11, 1 Novembre 1995, pages 1994-1997, XP000541543 HAN H ET AL: "INGAAS-ALGAAS-GAAS STRAINED-LAYER QUANTUM-WELL HETEROSTRUCTURE SQUARE RING LASERS"

## Description

La présente invention est relative à un procédé pour la réalisation de plans inclinés à 45° sur un substrat d'InP.

Un tel procédé est connu de US-A-4 595 454.

Elle concerne également des composants optiques comportant des substrats d'InP présentant des plans inclinés à 45° réalisés selon ce procédé.

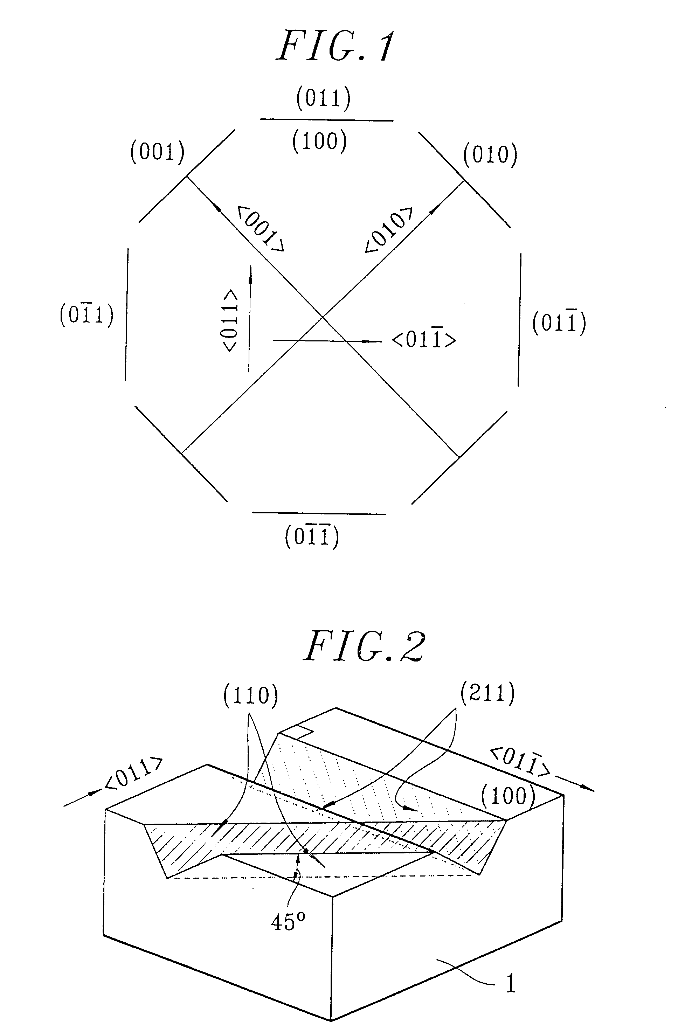

On a représenté sur la figure 1 les plans cristallins d'un substrat d'InP, orienté parallèlement au plan (100).

On a en particulier représenté sur cette figure les petits et grands méplats correspondant respectivement aux plans (0,-1, 1), (0, 1, -1) et aux plans (0, 1, 1), (0, -1, -1), ainsi que les plans (0, 0, 1), (0, 0, -1) et (0, 1, 0) et (0,-1, 0).

Classiquement, pour réaliser un miroir à 45° sur une telle structure, on mettait en oeuvre une gravure par voie sèche dans les directions <011> ou <01-1>, en utilisant les techniques de gravure par faisceau d'ions (Ion Beam Etching ou IBE selon la terminologie anglo-saxonne), de gravure par faisceaux d'ions réactifs (Reactive Ion Beam Etching ou RIBE) ou encore par gravure ionique réactive (Reactive Ion Etching ou RIE).

On notera en particulier que des attaques selon ces deux directions <011> et <01-1> permettent d'utiliser comme plans de clivage les plans perpendiculaires à ces deux directions, ces plans constituant en effet des plans de moindre cohésion faciles à cliver.

Les techniques IBE, RIBE ou RIE sont toutefois d'une grande complexité. Elles font appel à du matériel lourd et coûteux et obligent à manipuler des gaz dangereux (chlore, hydrogène, méthane).

Et à ce jour, les attaques chimiques réalisées sur InP ne permettent de réaliser que des rainures en V dont les faces sont orientées à 56° par rapport au plan (1,0,0). On pourra à cet égard se référer à la publication :

"Application of V-Groove technology to InP solar cells", Bailey et al., Proceedings of the Indium Phosphide and Related Materials Conference, Denver, Apr. 23-25, 1990, Vol. 1, n° Conf. 2, 23 avril 1990, Institute of Electrical and Electronics Engineers, Pages 73-79.

L'invention propose quant à elle un procédé pour la réalisation de plans inclinés à 45° sur un substrat d'InP qui est d'une plus grande simplicité.

Plus particulièrement, le procédé proposé par l'invention est tel que pour un substrat d'InP orienté parallèlement au plan (100), on réalise une attaque chimique selon la direction <001> ou <010>.

L'invention propose également un composant optique comportant un substrat d'InP qui présente au moins un plan incliné à 45° réalisé conformément au procédé précité.

Ce composant optique est par exemple un composant d'émission laser à émission par la surface dont un miroir de réflexion pour la lumière émise par la couche active dudit composant est défini par un plan incliné à 45° sur ledit substrat.

En particulier, dans une variante de réalisation avantageuse, le composant comporte une cavité polygonale dont les miroirs sont définis par des plans de son substrat inclinés à 45° et réalisés conformément au procédé précité, ainsi que par des plans de clivage du substrat.

D'autres caractéristiques et avantages de l'invention ressortiront encore de la description qui suit. Cette description est purement illustrative et non limitative. Elle doit être lue en regard des dessins annexés sur lesquels :
- la figure 1, déjà discutée, illustre la structure cristalline d'un substrat d'InP ;
- la figure 2 est une représentation schématique illustrant la disposition des miroirs à 45° que permet de réaliser le procédé proposé par l'invention par rapport aux miroirs obtenus avec les techniques de l'art antérieur, sur un même substrat d'InP ;
- les figures 3 et 4 illustrent les composants d'émission laser par la surface comportant des miroirs à 45° réalisés avec le procédé proposé par l'invention ;
- la figure 5 illustre un composant comportant des miroirs à 45° réalisés selon le procédé conforme à l'invention ;
- les figures 6a et 6b illustrent les réflexions qui interviennent sur le composant de la figure 5.

On se réfère à nouveau à la figure 1.

Selon le procédé proposé par l'invention, il est proposé de réaliser une attaque chimique humide localisée dans la direction <001> ou dans la direction <010> sur un substrat d'InP orienté selon le plan (1,0,0).

Une telle attaque chimique localisée permet de révéler les plans (1, 1, 0), (1,-1, 0), (1, 0, 1) et (-1, 0, 1) (et les plans équivalents) qui sont orientés à 45° par rapport au plan (1, 0, 0) (et ses plans équivalents).

C'est ce qu'on a illustré sur la figure 2 sur laquelle on a représenté les plans (1, 1, 0) et (1, -1, 0) révélés sur un substrat 1 d'InP orienté selon le plan (1, 0, 0) avec une attaque chimique dans la direction <001>.

On a également porté sur cette figure 2 des miroirs obtenus par une attaque dans la direction <01-1>.

Ces miroirs sont toutefois des plans (2, 1, 1), qui ne sont pas inclinés à 45° par rapport au plan (1, 0, 0), mais sont inclinés à 35° 24'ou 54°46'.

Une mise en oeuvre de l'invention pour la réalisation de plans inclinés à 90° l'un par rapport à l'autre sur un substrat d'InP orienté (1, 0, 0) va maintenant être décrite.

On dépose sur le substrat d'InP une couche de 1000 Å de nitrure de silicium (Si Nx). Ce dépôt est réalisé par technologie PECVD (dépôt assisté par plasma en phase vapeur) à 250°.

Dans un deuxième temps, on grave par photolithographie sur cette couche de nitrure un ruban dans la direction <001> (ou les directions équivalentes). Ce ruban est choisi avec une largeur fonction de l'espacement souhaité entre les miroirs à 45° qui vont être révélés par l'attaque chimique.

On met l'échantillon avec son nitrure ainsi gravé dans un mélange d'acide chlorhydrique et d'acide orthophosphorique, qui va attaquer la couche d'InP là où elle n'est pas protégée par la couche de nitrure de silicium.

Cette attaque par l'acide chlorhydrique permet une gravure sur une épaisseur de 15 *µ*m pour une solution comportant un volume d'HCl pour un volume d'H₃PO₄ concentré et une durée d'attaque d'un quart d'heure à température ambiante.

Cette attaque met à nu les plans (1, 1, 0) et (1, -1, 0) dans la longueur du ruban gravé et révèle par conséquent deux miroirs orientés à 90° l'un par rapport à l'autre.

La technique qui vient d'être décrite est avantageusement utilisée pour réaliser des miroirs à 45° sur des composants optiques, notamment des composants lasers à émission par la surface.

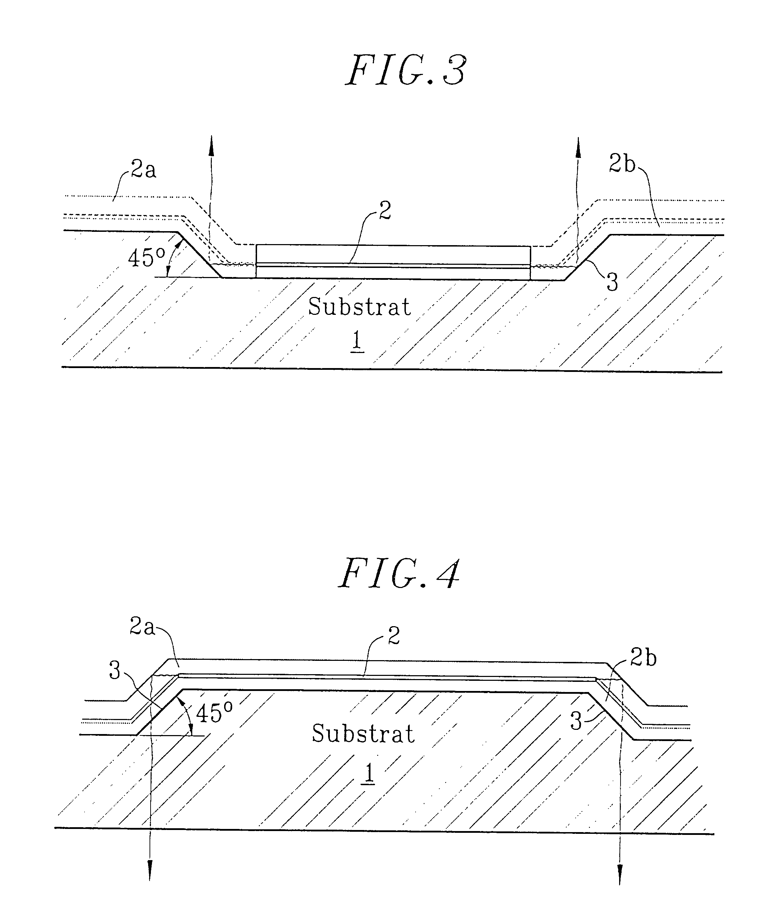

C'est ce qu'on a illustré sur la figure 3 sur laquelle on a représenté schématiquement un substrat 1, une couche active 2 entre deux couches de confinement optique 2a, 2b, ainsi que des miroirs 3 à 45° gravés sur le substrat 1 selon le procédé qui vient d'être décrit de part et d'autre de la zone active.

Les faisceaux émis par la couche active 2 sont ainsi réfléchis par les miroirs 3, à 90° par rapport au plan du substrat 1.

Le composant illustré sur la figure 3 est un composant à émission directe. L'invention s'applique bien entendu également de la même façon, ainsi qu'on l'a illustré sur la figure 4, à un composant laser à émission par la surface de son substrat.

Dans cet exemple, les faisceaux émis sont réfléchis par les miroirs que constituent les interfaces entre d'une part la couche de confinement supérieure 2a au droit des plans inclinés à 45° réalisés sur le substrat 1 au moyen d'un procédé conforme à l'invention, et d'autre part l'air ou le matériau déposé sur ladite couche de confinement supérieur. '

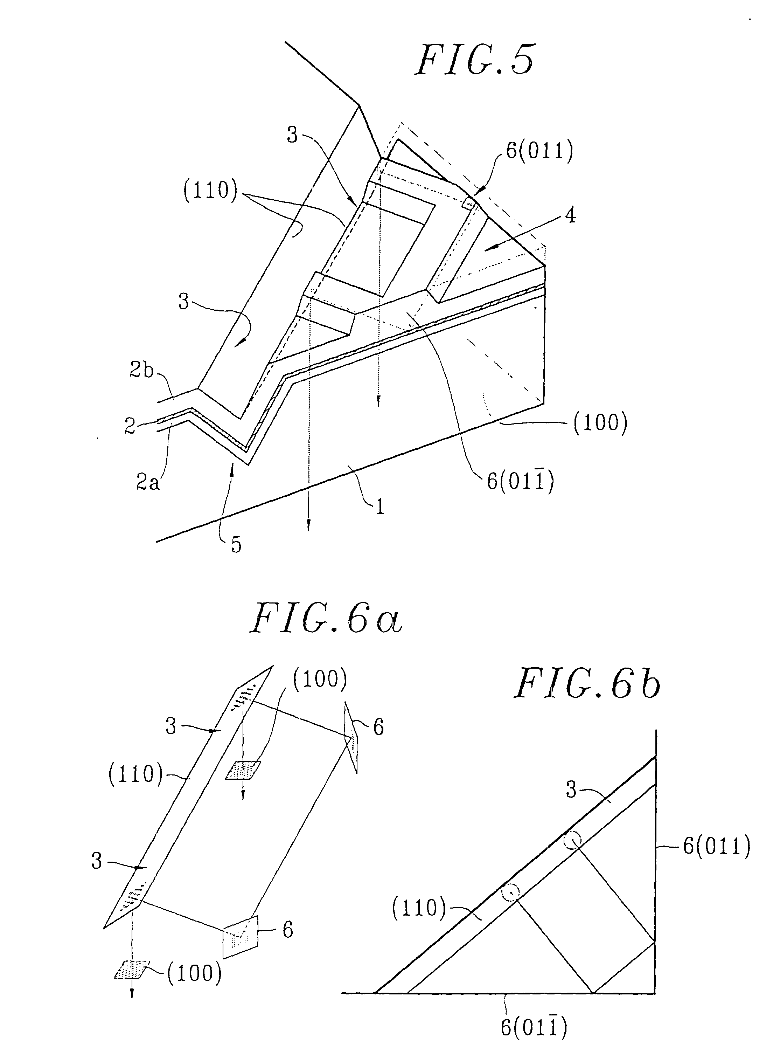

Le composant illustré sur la figure 5 est un composant laser à émission par la surface de son substrat qui présente une cavité polygonale.

Les composants à cavités polygonales sont déjà connus de l'état de la technique.

Celui qui est illustré sur la figure 5 comporte des miroirs définis par des plans du substrat inclinés à 45° et réalisés selon le procédé conforme à l'invention.

Plus précisément, le composant illustré sur cette figure 5 comporte un substrat 1, par exemple d'InP, ainsi qu'une couche active 2 et des couches de confinement optique 2a, 2b déposées sur ledit substrat 1.

Une cavité 4 en U est ménagée au niveau d'un coin en angle droit du composant. Cette cavité en U utilise les plans de clivage naturels du substrat - plan (01-1) et plan (011) sur la figure 5 - comme miroirs de réflexion à 90° entre les différentes portions de guides d'onde qui définissent la cavité en U. Ces miroirs ont été référencés par 6 sur la figure.

Sur le substrat 1, on a, préalablement au dépôt de la couche active 2 et des couches de confinement 2a, 2b, ménagé dans la direction <011> une rainure 5 en V en mettant en oeuvre le procédé selon l'invention. Les plans (110) mis à nus par cette rainure 5 en V définissent - après dépôt de la couche 2 et des couches 2a, 2b - aux extrémités des branches de la cavité en U des miroirs 3 de réflexion qui réfléchissent la lumière en sortie de la cavité 4 à travers le substrat 1 du composant.

Les réflexions ainsi réalisées par ces miroirs 3, ainsi que par les miroirs 6 correspondant aux plans de clivage du substrat 1, ont été illustrées sur les figures 6a et 6b.

Comme on l'aura compris, le faisceau en sortie du composant est perpendiculaire au plan (110) du substrat 1 et est émis par la surface à travers celui-ci.

## Revendications

1. Procédé pour la réalisation d'au moins un plan incliné sur un substrat d'InP orienté parallèlement au plan (100), caractérisé en ce qu'on réalise une attaque chimique localisée selon la direction <001> ou <010> au moyen d'un mélange d'acide chlorhydrique et d'acide phosphorique.

2. Procédé selon la revendication 1, caractérisé en ce qu'on dépose sur le substrat d'InP, préalablement à l'attaque chimique, un masque sur lequel on grave par photolithographie les zones destinées à subir une attaque chimique.

3. Composant optique comportant un substrat d'InP orienté parallèlement au plan (100), caractérisé en ce que le substrat présente au moins un plan incliné à 45° qui coupe le plan du substrat selon la direction <001> ou <010>° et qui est réalisé conformément au procédé selon l'une des revendications 1 et 2.

4. Composant selon la revendication 3, caractérisé en ce qu'il est un composant d'émission laser à émission par la surface, et en ce que le plan incliné à 45° de son substrat définit un miroir de réflexion pour la lumière émise par la couche active dudit composant.

5. Composant selon la revendication 4, caractérisé en ce qu'il comporte une cavité polygonale dont les miroirs (3, 6) sont définis par des plans de son substrat (1) inclinés à 45, ainsi que par des plans de clivage (6) dudit substrat (1).

## Claims

1. A method of making at least one inclined plane on an InP substrate oriented parallel to the (1, 0, 0) plane, the method being characterized in that localized chemical etching is performed in the <001> or <010> direction by means of a mixture of hydrochloric acid and of phosphoric acid.

2. A method according to claim 1, characterized in that prior to chemical etching, a mask is deposited on the InP substrate and zones that are to be subjected to chemical etching are etched thereon by photolithography.

3. An optical component comprising an InP substrate oriented parallel to the (1, 0, 0) plane, the component being characterized in that the substrate has at least one plane inclined at 45° occupying the substrate plane in the <001> or <010> direction and made in application of the method according to claim 1 or 2.

4. A component according to claim 3, characterized in that it is a surface-emitting laser emitter component, and in that the plane inclined at 45° of its substrate defines a reflection mirror for the light emitted by the active layer of said component.

5. A component according to claim 4, characterized in that it has a polygonal cavity whose mirrors (3, 6) are defined by planes of its substrate (1) inclined at 45°, and also by cleavage planes (6) of said substrate (1).

## Patentansprüche

1. Verfahren für die Fertigung wenigstens einer geneigten Ebene auf einem InP-Substrat, das parallel zur Ebene (100) orientiert ist, dadurch gekennzeichnet, daß mittels einer Mischung aus Salzsäure und Phosphorsäure eine entlang der Richtung <001> oder <010> verlaufende chemische Ätzung durchgeführt wird.

2. Verfahren nach Anspruch 1, dadurch gekennzeichnet, daß auf dem InP-Substrat, vor der chemischen Ätzung, eine Maske aufgetragen wird, auf der per Lithographie die Bereiche geätzt werden, welche für eine chemische Ätzung bestimmt sind.

3. Optisches Bauteil, welches ein InP-Substrat umfaßt, das parallel zur Ebene (100) orientiert ist, dadurch gekennzeichnet, daß das Substrat wenigstens eine um 45° geneigte Ebene aufweist, welche die Ebene des Substrats entlang der Richtung <001> oder <010> schneidet und welche gemäß einem Verfahren nach einem der Ansprüche 1 und 2 hergestellt wird.

4. Bauteil nach Anspruch 3, dadurch gekennzeichnet, daß es ein Laseremissionsbauteil mit Emission durch die Fläche ist, und daß die um 45° geneigte Ebene seines Substrats einen Reflexionsspiegel für das durch die aktive Schicht des Bauteils ausgestrahlte Licht definiert.

5. Bauteil nach Anspruch 4, dadurch gekennzeichnet, daß es eine polygonale Kavität umfaßt, von der die Spiegel (3,6) durch um 45° geneigte Ebenen seines Substrats (1) sowie durch Spaltebenen (6) des Substrats (1) definiert sind.
